Europäisches Patentamt

European Patent Office

Office européen des brevets

(19)

(11) **EP 1 235 113 A2**

(12) **EUROPÄISCHE PATENTANMELDUNG**

(43) Veröffentlichungstag:
    **28.08.2002 Patentblatt 2002/35**

(51) Int Cl.⁷: **G03F 7/20**

(21) Anmeldenummer: **02002075.6**

(22) Anmeldetag: **11.02.2002**

(84) Benannte Vertragsstaaten:
    **AT BE CH CY DE DK ES FI FR GB GR IE IT LI LU
    MC NL PT SE TR**
    Benannte Erstreckungsstaaten:
    **AL LT LV MK RO SI**

(30) Priorität: **29.09.2001 DE 10148308
                20.03.2001 DE 10113613
                23.02.2001 DE 10108677**

(71) Anmelder: **CARL ZEISS SEMICONDUCTOR
    MANUFACTURING TECHNOLOGIES AG
    73447 Oberkochen (DE)**

(72) Erfinder:
    • **Köhler, Jess, Dr.
      73447 Oberkochen (DE)**
    • **Sohmer, Alexander
      73447 Oberkochen (DE)**

(54) **Beleuchtungssystem mit reduzierter energetischer Belastung**

(57) Beleuchtungssystem (1) insbesondere für eine Mikrolithographie-Projektionsbelichtungsanlage mit einer optischen Achse (OA). Das Beleuchtungssystem (1) umfaßt einen Stabintegrator (3) und ein nachfolgendes Objektiv (11) zur Abbildung eines Objektfeldes (13) auf ein Bildfeld (15). Der Stabintegrator (3) weist eine Eintrittsfläche (5) und eine Austrittsfläche (7) mit einer Breite und einer Höhe, sowie reflektierende Seitenflächen (9) auf. In dem Objektiv (11) befindet sich ein linsenfreier Zwischenraum (17) mit einer axialen Dicke ($d_{LF}$) von mindestens 30mm. Innerhalb dieses Zwischenraums befindet sich eine Ebene, die optisch konjugiert zur Ebene der Eintrittsfläche (5) ist. Alle Strahlen (21), welche von einem zentralen Feld (19) innerhalb der Eintrittsfläche (5) des Stabintegrators (3) ausgehen und nicht an den Seitenflächen (9) reflektiert werden, weisen in dem linsenfreien Zwischenraum (17) geringere Strahlhöhen in Bezug auf die optische Achse (OA) auf als alle Strahlen (23), die von dem gleichen zentralen Feld (19) ausgehen und an den Seitenflächen (9) reflektiert werden, wobei das zentrale Feld (19) eine Feldbreite und eine Feldhöhe aufweist und das Verhältnis der Feldbreite zur Breite der Eintrittsfläche (5) maximal 0,7, insbesondere maximal 0,5, und das Verhältnis der Feldhöhe zur Höhe der Eintrittsfläche (5) maximal 0,7, insbesondere maximal 0,5, beträgt.

**FIG.1**

**Beschreibung**

Die Erfindung betrifft ein Beleuchtungssystem insbesondere für eine Mikrolithographie-Projektionsbelichtungsanlage gemäß dem Oberbegriff des Patentanspruchs 1 oder 2. Ein derartiges Beleuchtungssystem ist aus der DE 195 20 563 A1 bekannt.

Das Beleuchtungssystem ist entlang einer optischen Achse aufgebaut und umfaßt einen Stabintegrator und ein in Lichtrichtung nachfolgendes Objektiv, das ein Objektfeld auf ein Bildfeld abbildet.

Bei dem Beleuchtungssystem der DE 195 20 563 A1 wird die Eintrittsfläche des Stabintegrators von einer Einkoppeloptik beleuchtet. Der Stabintegrator, beispielsweise ein Glasstab oder ein Hohlleiter, mischt und homogenisiert durch mehrfache innere Reflexion das eintretende Strahlenbüschel, so daß an der Austrittsfläche des Stabintegrators eine nahezu homogene Intensitätsverteilung erzeugt wird. In der Nähe der Austrittsfläche des Stabintegrators befindet sich eine Maskierungseinrichtung, die mit einem nachfolgenden Objektiv, dem sogenannten REMA(Reticle Masking)-Objektiv auf eine Struktur tragende Maske, das sogenannte Retikel, abgebildet wird, wodurch der ausgeleuchtete Bereich auf dem Retikel scharf begrenzt wird. Ein weiteres Beleuchtungssystem mit einem Glasstab und einem nachfolgenden REMA-Objektiv ist aus der DE 44 21 053 A1 bekannt.

Die DE 199 12 464 A1 beschreibt ebenfalls ein Beleuchtungssystem mit einem Stabintegrator. Die Austrittsfläche des Stabintegrators wird dabei mit einem Objektiv auf das Retikel abgebildet.

Die zuvor zitierten Schriften enthalten jedoch keine Hinweise auf eine konkrete Ausführung des Objektivs, das jeweils nach dem Stabintegrator angeordnet ist.

Ausführungsbeispiele für REMA-Objektive werden in der DE 195 48 805 A1 und in der DE 196 53 983 A1 gezeigt. Diese Schriften zeigen auch Projektionsbelichtungsanlagen mit einem Glasstab als Stabintegrator und einem nachfolgenden REMA-Objektiv.

Aufgabe der Erfindung ist es, ein verbessertes Beleuchtungssystem mit einem Stabintegrator und einem nachfolgenden Objektiv anzugeben, bei dem insbesondere die energetische Belastung der Linsen innerhalb des Objektives reduziert ist.

Gelöst wird diese Aufgabe mit einem Beleuchtungssystem gemäß Anspruch 1 oder 2. Vorteilhafte Ausgestaltungen der Erfindung ergeben sich aus den Merkmalen der abhängigen Ansprüche.

Die energetische Belastung der Linsen des Objektivs wird dadurch reduziert, daß das Objektiv einen linsenfreien Zwischenraum aufweist, wobei die Position und die axiale Dicke des linsenfreien Zwischenraums primär von den Abmessungen des Stabintegrators abhängt. Der Stabintegrator weist eine Eintritts- und Austrittsfläche mit einer Breite und einer Höhe und vier Seitenflächen mit einer Länge entlang der optischen Achse auf. Die Eintrittsfläche ist nicht auf einen rechteckigen Querschnitt beschränkt. Sie kann auch eine polygonale Außenform aufweisen, wobei sich der Querschnitt der Eintrittsfläche jeweils in ein Rechteck mit einer Breite und einer Höhe einschreiben läßt. Der Stabintegrator kann aus mehreren Stabintegratoren aufgebaut sein, die unmittelbar aufeinander folgen. Es ist auch möglich, zwischen den einzelnen Stabintegratoren ein Umlenkspiegel oder ein Umlenkprisma anzubringen. Die Länge des Stabintegrators ergibt sich dann als Summe der einzelnen Längen der zusammengesetzten Stabintegratoren.

Innerhalb des Objektives gibt es gemäß Anspruch 1 eine zur Ebene der Eintrittsfläche optisch konjugierte Ebene. In dieser Ebene entstehen Bilder der Eintrittsfläche. Die Zahl der Bilder hängt von der Anzahl der Reflexionen der Strahlen innerhalb des Stabintegrators ab. Diese zur Ebene der Eintrittsfläche optisch konjugierte Ebene befindet sich innerhalb des linsenfreien Zwischenraums, der vorteilhafterweise eine axiale Dicke von mindestens 30mm, insbesondere von mindestens 50mm aufweist. Die zur Ebene der Eintrittsfläche optisch konjugierte Ebene befindet sich vorteilhafterweise nahezu in der Mitte des linsenfreien Zwischenraums.

Eine weitere Möglichkeit, die Lage und Dicke des linsenfreien Zwischenraums zu bestimmen, ist in Anspruch 2 aufgezeigt. Dazu werden Strahlen innerhalb des Beleuchtungssystems betrachtet, die von der Eintrittsfläche des Stabintegrators ausgehen und durch das Beleuchtungssystem geführt werden. Hierbei wird zwischen Strahlen, die den Stabintegrator ohne Reflexion an den Seitenflächen durchlaufen, und Strahlen, die an den Seitenflächen einmal oder mehrmals reflektiert werden, unterschieden. Innerhalb des Objektives gibt es einen Bereich, in dem die Strahlen, die nicht reflektiert werden, geringere Strahlhöhen aufweisen als die Strahlen, die einmal oder mehrmals reflektiert werden. Dieser Bereich definiert den linsenfreien Zwischenraum. Die Strahlhöhen geben dabei den Abstand der Strahlen zu der optischen Achse an. Zur Bestimmung des linsenfreien Zwischenraums werden nicht alle prinzipiell möglichen Strahlen betrachtet, sondern nur diejenigen Strahlen, die von einem zentralen Feld in der Eintrittsfläche des Stabintegrators ausgehen. Die Feldbreite des zentralen Feldes beträgt dabei maximal 70% der Breite der Eintrittsfläche, insbesondere maximal 50% der Breite der Eintrittsfläche. Die Feldhöhe des zentralen Feldes beträgt maximal 70% der Höhe der Eintrittsfläche, insbesondere maximal 50% der Höhe der Eintrittsfläche. Je kleiner das zentrale Feld ist, von dem die Strahlen zur Bestimmung des linsenfreien Zwischenraums ausgehen, um so ausgedehnter ist der linsenfreie Zwischenraum. Das zentrale Feld beschränkt dabei nicht den ausgeleuchteten Bereich auf der Eintrittsfläche, sondern gibt den Ursprungsort der Strahlen an, die zur Bestimmung des linsenfreien Zwischenraums herangezogen werden.

Der Zwischenraum ist dann linsenfrei, wenn sich innerhalb des Zwischenraums auf der optischen Achse kein Flächenscheitel einer Linse befindet. Der linsenfreie Zwischenraum weist eine Gasfüllung mit Luft, einem inerten Gas oder einer Mischung von inerten Gasen auf oder kann evakuiert sein.

Die vorteilhafte Wirkung der Erfindung besteht darin, daß lokale Intensitätsspitzen, die bei einem Beleuchtungssystem mit einem Stabintegrator und einem nachfolgenden Objektiv innerhalb des Objektives auftreten, zu keinen Materialschädigungen führen. Die lokalen Intensitätsspitzen innerhalb des linsenfreien Zwischenraums treten dann auf, wenn das Licht möglichst verlustfrei in den Stabintegrator eingekoppelt wird. Dazu wird in der Nähe der Eintrittsfläche des Stabintegrators eine Einschnürung des Strahlenbüschels, eine sogenannte sekundäre Lichtquelle, durch die vor dem Stabintegrator angeordneten optischen Komponenten erzeugt. Die laterale Ausdehnung der reellen sekundären Lichtquelle ist möglichst kleiner als der Querschnitt der Eintrittsfläche. Durch die Vielfachreflexionen innerhalb des Stabintegrators werden in der Ebene der reellen sekundären Lichtquelle ein Gitter von virtuellen sekundären Lichtquellen erzeugt, wobei die Strahlen einer virtuellen Lichtquelle jeweils gleich viele Reflexionen an den Seitenflächen des Stabintegrators erfahren. Die Gitterperiode der virtuellen sekundären Lichtquellen ist in der x-Richtung gleich der Breite der Eintrittsfläche und in y-Richtung gleich der Höhe der Eintrittsfläche, wenn die Breite in x-Richtung und die Höhe in y-Richtung gemessen wird. Da die reelle sekundäre Lichtquelle in der Mitte des Gitters die entsprechende Gitterzelle nicht vollständig ausfüllt, sind auch die virtuellen Gitterzellen nicht vollständig ausgeleuchtet. Das Gitter der virtuellen sekundären Lichtquellen wird durch die Linsen des auf den Stabintegrator nachfolgenden Objektives auf ein Gitter mit reellen tertiären Lichtquellen abgebildet, dessen Lage innerhalb des Objektives primär von der Länge des Stabintegrators abhängt. Das Gitter mit den tertiären Lichtquellen befindet sich dabei nahe bei der zur Ebene der Eintrittsfläche optisch konjugierten Ebene. Wird das Gitter mit den virtuellen sekundären Lichtquellen direkt in der Ebene der Eintrittsfläche erzeugt, so liegt das Gitter mit den tertiären Lichtquellen in der zur Ebene der Eintrittsfläche optisch konjugierten Ebene. In der Ebene mit den tertiären Lichtquellen treten große Intensitätsschwankungen auf, wobei sich am Ort der tertiären Lichtquellen die lokalen Intensitätsspitzen befinden. Dieser Zusammenhang zwischen dem Stabintegrator und der lokalen energetischen Belastung der Linsen eines nachfolgenden Objektives wurde in den unter anderem aus der DE 195 48 805 A1 und der DE 196 53 983 A1 bekannten Ausführungsformen eines REMA-Objektives nicht berücksichtigt.

Das Objektiv ist nun derart aufgebaut, daß sich das Gitter mit den tertiären Lichtquellen innerhalb des linsenfreien Zwischenraums befindet. Die Bestimmung der Lage des linsenfreien Zwischenraums erfolgt gemäß Anspruch 1, indem die zur Ebene der Eintrittsfläche des Stabintegrators optisch konjugierte Ebene innerhalb des Objektivs bestimmt wird, oder gemäß Anspruch 2 mit Zuhilfenahme ausgewählter Strahlen. Die zur Bestimmung des linsenfreien Zwischenraums herangezogenen Strahlen, die an den Seitenwänden des Stabintegrators nicht reflektiert werden, gehören zu der zentralen tertiären Lichtquelle, während die einmal oder mehrmals reflektierten Strahlen zu den außeraxialen tertiären Lichtquellen gehören. Durch den linsenfreien Zwischenraum wird erreicht, daß außerhalb des Zwischenraums das Verhältnis der Intensitäten der von den tertiären Lichtquellen bedingten lokalen Intensitätsmaxima zu den Intensitäten der dazwischen liegenden lokalen Intensitätsminima kleiner 2,0 ist, wenn man von einer zentralen sekundären Lichtquelle ausgeht, welche die zentrale Gitterzelle zu 50% füllt.

Der linsenfreie Zwischenraum hat dabei vorteilhaft eine Dicke entlang der optischen Achse von mindestens 30mm, insbesondere von mindestens 50mm, so daß die Flächenscheitel der vor und nach dem Zwischenraum angeordneten Linsen mindestens diesen Abstand aufweisen.

Innerhalb des Objektives einen Zwischenraum dieser Dicke einzuführen, ist besonders dann schwierig, wenn das Objektiv ein großes Objektfeld und eine große numerische Apertur aufweist. So beträgt der Durchmesser des Objektfeldes des Objektives zwischen 15mm und 40mm und die objektseitige numerische Apertur zwischen 0,4 und 0,75. Die objektseitige numerische Apertur gibt dabei die Apertur an, die durch den maximalen Blendendurchmesser des Objektivs begrenzt wird. Um diesen großen Lichtleitwert, der sich als Produkt aus dem Durchmesser des Objektfeldes und der objektseitigen numerischen Apertur ergibt, übertragen zu können, ist eine große Anzahl von Linsen erforderlich. Gerade mit den Linsen im Bereich der Blende werden dabei die Öffnungsfehler korrigiert, so daß in diesem Bereich die Linsen üblicherweise unmittelbar aufeinander folgen.

Das Gitter mit den tertiären Lichtquellen befindet sich jedoch bei üblicherweise zum Einsatz kommenden Stabintegratoren im Bereich der blendennahen Linsengruppe, in welcher der vom äußersten Objektpunkt ausgehende Hauptstrahl geringere Strahlhöhen aufweist als der Randstrahl, der von einem Objektpunkt auf der optischen Achse ausgeht und dessen Strahlwinkel der maximalen objektseitigen Apertur entspricht.

In dieser blendennahen Linsengruppe einen derart breiten linsenfreien Zwischenraum einzuführen, läßt sich nur über den Vorteil der Reduzierung der energetischen Belastung der Linsen rechtfertigen. Eine alternative Lösung wäre, Linsen, die im Bereich der tertiären Lichtquellen angeordnet sind, aus bestrahlungsbeständigen Materialien aufzubauen. Bei Wellenlängen von 193nm oder 157nm stehen dazu jedoch nur Fluorid-Kristalle wie beispielsweise $CaF_2$ oder $MgF_2$ zur Verfügung, die teuer und aufwendig in der Bearbeitung sind.

Der Abstand der Ebene mit den virtuellen sekundären Lichtquellen von der Objektebene des nachfolgenden Objektivs ist gleich der Summe aus dem Abstand der reellen sekundären Lichtquelle von der Eintrittsfläche des Stabintegrators, der Länge des Stabintegrators und einer eventuellen Defokussierung der Objektfläche von der Austrittsfläche des Stabintegrators. Der Abstand der reellen sekundären Lichtquelle von der Eintrittsfläche und die Defokussierung sind dabei jedoch im Vergleich zur Länge des Stabintegrators zu vernachlässigen. Die Länge des Stabintegrators ist so zu wählen, daß sich innerhalb des Objektfeldes eine vorgegebene Uniformität der Beleuchtungsverteilung ergibt, die üblicherweise besser 5%, insbesondere besser 1% ist. Dies wird erreicht, wenn die in den Stabintegrator eintretenden Strahlen im Mittel 1,5-fach bis 4,5-fach reflektiert werden. Eine größere Anzahl von Reflexionen würde zwar die Uniformität erhöhen, jedoch bei vorgegebener Apertur zu einer größeren Stablänge führen und damit die Transmission des Stabintegrators verschlechtern. Zudem würde sich der für das Beleuchtungssystem benötigte Bauraum vergrößern. Die Zahl der Reflexionen hängt bei einem Stabintegrator von der Länge $L_{SI}$, dem Querschnitt der Eintrittsfläche und dem Eintrittswinkel der Strahlen ab. Der Sinus des maximalen Eintrittswinkels ergibt sich aus dem Produkt von Füllfaktor $\sigma$ und maximaler objektseitiger Apertur $NA_{Obj}$, dividiert durch die Brechzahl $n_{SI}$ des Stabintegrators, welche bei einem Hohlleiter gleich der Brechzahl der Gasfüllung und bei einem Glasstab gleich der Brechzahl des Stabmaterials ist. Der Füllfaktor $\sigma$ gibt das Verhältnis der maximalen Apertur der in den Stabintegrator eintretenden Strahlen zu der objektseitigen numerischen Apertur des Objektives an. Der Füllfaktor $\sigma$ kann durch die vor dem Stabintegrator angeordneten optischen Komponenten beispielsweise zwischen 0,2 und 1,0 variiert werden. Somit variiert der maximale Strahlwinkel an der Eintrittsfläche des Stabintegrators zwischen 20% und 100% der maximalen objektseitigen numerischen Apertur $NA_{Obj}$ des Objektives. Da bei geringeren Strahlwinkeln die Zahl der Reflexionen ebenfalls geringer ist, muß die für die Uniformität erforderliche Stablänge an den minimal möglichen Füllfaktor $\sigma$ angepaßt werden. Die rechteckige Eintrittsfläche des Stabintegrators weist ein Seitenaspektverhältnis $R_{xy}$ von Breite zu Höhe zwischen 1 und 5 auf. Die Breite $B_{SI}$ der Eintrittsfläche ergibt sich vorteilhafterweise aus dem Durchmesser $Du_{Obj}$ des Objektives gemäß folgender Beziehung:

$$0,8 \cdot Du_{Obj} \cdot \sqrt{1+\frac{1}{R_{xy}^2}} < B_{SI} < 1,2 \cdot Du_{Obj} \cdot \sqrt{1+\frac{1}{R_{xy}^2}} \qquad (1)$$

Die Grenzen 0,8 und 1,2 geben Toleranzen an, die sich auf Grund der Dezentrierung des Stabintegrators zur Objektebene des Objektives ergeben. Durch die Beziehung (1) mit den engen Grenzen für die Breite der Eintrittsfläche wird sichergestellt, daß zum einen das Objektfeld des Objektives optimal ausgenutzt wird und zum anderen das in den Stabintegrator eingekoppelte Licht nahezu vollständig durch das Objektfeld des Objektivs tritt.

In Hinblick auf die für die Uniformität erforderliche Anzahl von Reflexionen ist die größere Abmessung der Eintrittsfläche, in diesem Fall die Breite $B_{SI}$, relevant, da ein Strahl, der in der x-z-Ebene einfällt, eine geringere Anzahl von Reflexionen erleidet als ein Strahl, der in der y-z-Ebene einfällt. Die Breite $B_{SI}$ wird dabei in x-Richtung und die Höhe in y-Richtung gemessen. Aus den für ein Beleuchtungssystem bekannten Größen kann der Wertebereich für die Länge $L_{SI}$ des Stabintegrators gemäß folgender Beziehung abgeleitet werden:

$$1,5 \cdot \frac{B_{SI}}{\tan\left(\arcsin\left(\frac{NA_{Obj} \cdot \sigma}{n_{SI}}\right)\right)} < L_{SI} < 4,5 \cdot \frac{B_{SI}}{\tan\left(\arcsin\left(\frac{NA_{Obj} \cdot \sigma}{n_{SI}}\right)\right)} \qquad (2)$$

Für Objektive mit einem Durchmesser des Objektfeldes im Bereich von 25mm bis 35mm und einer objektseitigen numerischen Apertur zwischen 0,6 und 0,75 haben die Stabintegratoren vorteilhafterweise eine Länge zwischen 350mm und 800mm.

Durch die Vielfachreflexionen innerhalb des Stabintegrators verlaufen die Schwerstrahlen der Strahlenbüschel nach dem Stabintegrator nahezu parallel zur optischen Achse. Deshalb ist es vorteilhaft, wenn sich die Eintrittspupille des nachfolgenden Objektives im Unendlichen befindet.

Während die im Unendlichen liegende Eintrittspupille des Objektives durch die zwischen der Objektebene und der Blendenebene angeordneten Linsen auf die Blendenebene abgebildet wird, kommt das Gitter mit den tertiären Lichtquellen in Lichtrichtung nach der Blendenebene zum Liegen, da das Gitter mit den sekundären Lichtquellen einen endlichen Abstand zur Objektebene aufweist. Der Abstand zwischen der Blendenebene und dem Gitter mit den tertiären Lichtquellen kann so groß werden, daß es vorteilhaft ist, wenn eine Linsengruppe mit mindestens einer ersten Linse zwischen der Blendenebene und dem linsenfreien Zwischenraum angeordnet ist. Dadurch ist es möglich, einerseits Linsen zur Korrektur von Öffnungsfehlern nahe an der Blendenebene zu positionieren und andererseits mit dem linsenfreien Zwischenraum die energetische Belastung der Linsen in der Nähe der tertiären Lichtquellen zu reduzieren.

Die genannte erste Linse sollte so nah wie möglich an der Blendenebene angeordnet sein. Besonders bevorzugt ist der Abstand der genannten ersten Linse von der Blendenebene kleiner 30mm, insbesondere kleiner 10mm. Der Abstand wird dabei zwischen der Blendenebene und dem der Blendenebene zugewandten Flächenscheitel der genannten ersten Linse gemessen.

Um die Zahl der Linsen zu reduzieren und damit die Möglichkeit für einen ausgedehnten linsenfreien Zwischenraum zu schaffen, ist es vorteilhaft, wenn die genannte erste Linse eine asphärische Linsenfläche aufweist. Durch die asphärische Fläche in Blendennähe läßt sich der Hauptbeitrag zur sphärischen Aberration korrigieren.

Es ist besonders vorteilhaft, wenn in der Linsengruppe zwischen der Blendenebene und dem ausgedehnten linsenfreien Zwischenraum eine einzige Linse ausreichend ist, um den erforderlichen Beitrag zur Korrektur der Öffnungsfehler bereitzustellen.

Bei Stabintegratoren mit einem großen Seitenaspektverhältnis der Eintrittsfläche von mindestens 2:1, insbesondere 3:1, besonders bevorzugt 4:1 sind aufwendige optische Komponenten erforderlich, um die Form der realen sekundären Lichtquelle an die durch die Ausdehnung der Eintrittsfläche gegebene Gitterzelle anzupassen. Wird die zentrale Gitterzelle nur teilweise beleuchtet, beispielsweise nur zu 50%, so treten am Ort des Gitters mit den tertiären Lichtquellen große Intensitätsschwankungen auf. Die Erfindung läßt sich deshalb besonders vorteilhaft bei Stabintegratoren mit einem großen Seitenaspektverhältnis einsetzen, bei denen es aufwendig und schwierig ist, die zentrale Gitterzelle vollständig auszuleuchten.

Die Abbildungsleistung des Objektiv läßt sich an der Qualität eines Spotbildes innerhalb des Bildfeldes messen. Ein Spotbild stellt dabei das Bild eines Objektpunktes dar, wobei das von dem Objektpunkt ausgehende Strahlbüschel jeweils die maximale objektseitige numerische Apertur aufweist. Die Durchmesser aller Spotbilder betragen bei den erfindungsgemäßen Objektiven maximal 1% des Durchmessers des Bildfeldes. Die Korrektionsmittel zum Erreichen dieser Abbildungsleistung sind beispielsweise aus der DE 195 48 805 A1 und der DE 196 53 983 A1 bekannt, deren Offenbarungsgehalt vollumfänglich in die vorliegende Anmeldung mit aufgenommen wird. Die Erfindung gibt nun an, daß es trotz dieser guten Abbildungsleitung und der damit verbundenen aufwendigen Korrektur möglich ist, im Bereich der Blendenebene einen linsenfreien Zwischenraum zu schaffen, beispielsweise durch die Anordnung von mindestens einer Linse zwischen der Blendenebene und dem linsenfreien Zwischenraum sowie durch den Einsatz einer asphärischen Linsenfläche bei dieser Linse. Das Objektiv weist dabei vorteilhafterweise eine drei- bis achtfache Vergrößerung, insbesondere eine drei- bis fünffache Vergrößerung auf.

Ein weiterer vorteilhafter Einsatz dieser Erfindung ist im Zusammenhang mit Excimer-Lasern als Lichtquellen bei einer Wellenlänge kleiner 250nm zu sehen. Bei diesen Wellenlängen, insbesondere bei einer Wellenlänge von 193nm oder 157nm, kommt es durch große lokale Intensitätsbelastungen zu Materialschädigungen, beispielsweise zu Solarisation des Materials. Zudem handelt es sich um gepulste Lichtquellen, so daß die Strahlung durch singuläre Lichtpulse hoher Leistung gegeben ist. Dies ist besonders bei diesen niedrigen Wellenlängen mit hochenergetischen Photonen für das Linsenrnaterial eine starke Belastung.

Befindet sich in der Bildebene des Objektivs das Retikel einer Projektionsbelichtungsanlage, so ist es vorteilhaft, wenn die Größe des beleuchteten Bereichs auf dem Retikel variiert werden kann. Dies wird vorteilhaft erreicht, indem nach dem Stabintegrator in der Objektebene des Objektives, dem sogenannten REMA-Objektiv, eine Maskierungseinrichtung mit beweglichen Feldblenden angeordnet ist, die mit dem REMA-Objektiv auf das Retikel abgebildet wird.

Das Beleuchtungssystem mit Stabintegrator und REMA-Objektiv ist vorteilhafterweise Bestandteil einer Mikrolithographie-Projektionsbelichtungsanlage, wobei ein Projektionsobjektiv das Retikel auf ein lichtempfindliches Substrat abbildet. Die Austrittspupille des REMA-Objektives ist dabei an die Eintrittspupille des nachfolgenden Projektionsobjektives angepaßt.

Näher erläutert wird die Erfindung anhand der Zeichnungen.

Figur 1    zeigt eine schematische Darstellung eines erfindungsgemäßen Beleuchtungssystems;

Figur 2    zeigt einen Linsenschnitt eines ersten Ausführungsbeispiels mit einem Stabintegrator und einem Objektiv;

Figur 3    zeigt einen Ausschnitt aus dem Linsenschnitt von Figur 2;

Figur 4    zeigt in einer Höhenliniendarstellung die Ausleuchtung der Eintrittsfläche des Stabintegrators;

Figur 5    zeigt ein Diagramm der Intensitätsverteilung am Ort der tertiären Lichtquellen;

Figur 6    zeigt ein Diagramm der Intensitätsverteilung am Rand des linsenfreien Zwischenraums;

Figur 7    zeigt einen Linsenschnitt eines zweiten Ausführungsbeispiels mit einem Stabintegrator und einem Objektiv; und

Figur 8    zeigt eine schematische Darstellung einer Mikrolithographie-Proj ektionsbelichtungsanlage.

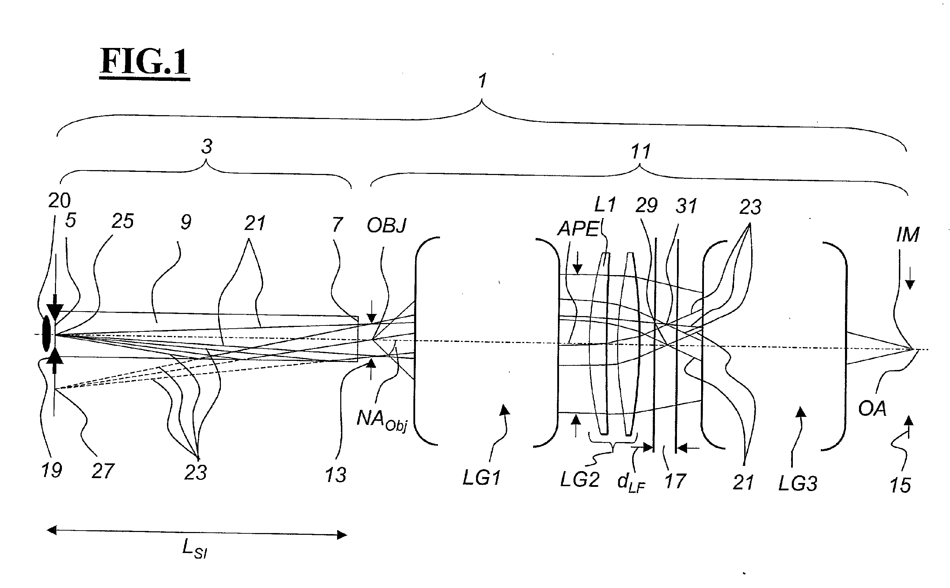

In Figur 1 ist das erfindungsgemäße Beleuchtungssystem 1 schematisch dargestellt. Es umfaßt den Stabintegrator 3 und das nachfolgende Objektiv 11. Der Stabintegrator 3, beispielsweise ein Hohlleiter oder ein Glasstab, weist die rechteckige Eintrittsfläche 5 und die Austrittsfläche 7, sowie die vier Seitenflächen 9 auf. Im Abstand von 0-2mm von der Austrittsfläche 7 folgt die Objektebene OBJ des Objektives 11. Das Objektiv 11 bildet das Objektfeld 13 in das in der Bildebene IM befindliche Bildfeld 15 ab. Es besteht aus der Linsengruppe LG1, welche die im Unendlichen liegende Eintrittspupille auf die Blendenebene APE abbildet, und den Linsengruppen LG2 und LG3, die zwischen der Blendenebene APE und der Bildebene IM angeordnet sind. Die Linsengruppe LG2 weist mindestens die Linse L1 auf. Zwischen der Linsengruppe LG2 und LG3 befindet sich der erfinderische linsenfreie Zwischenraum 17. Zu dessen Bestimmung werden Strahlen betrachtet, die von der reellen sekundären Lichtquelle 20 ausgehen, die im Bereich der Eintrittsfläche 5 des Stabintegrators 3 erzeugt wird. Hierbei wird zwischen Strahlen 21, die nicht an den Seitenflächen 9 des Stabintegrators reflektiert werden, und Strahlen 23, die einmal oder mehrmals an den Seitenflächen 9 reflektiert werden, unterschieden. Durch die Vielfachreflektionen innerhalb des Stabintegrators 3 werden in der Ebene der reellen sekundären Lichtquelle virtuelle Bilder der reellen sekundären Lichtquelle 20 erzeugt, so daß ein Gitter mit virtuellen sekundären Lichtquellen entsteht. Eingezeichnet sind nur die in der Darstellung auf einen Punkt reduzierte zentrale sekundäre Lichtquelle 25 und die virtuelle sekundäre Lichtquelle 27. Von der zentralen sekundären Lichtquelle 25 gehen die Strahlen 21 aus, die nicht an den Seitenwänden 9 reflektiert werden. Von der virtuellen Lichtquelle 27 gehen die Strahlen 23 aus, die an den Seitenwänden 9 einmal reflektiert werden. Sie sind von der virtuellen sekundären Lichtquelle 27 bis zum Reflexionspunkt an der Seitenwand 9 gestrichelt eingezeichnet, da es sich um virtuelle Strahlen handelt. Die zur virtuellen Lichtquelle 27 gehörenden reellen Strahlen, die von der reellen sekundären Lichtquelle 20 ausgehen, sind ebenfalls eingezeichnet. Während die im Unendlichen liegende Eintrittspupille des Objektivs 11 auf die Blendenebene APE abgebildet wird, befindet sich die zur Ebene der sekundären Lichtquellen konjugierte Ebene mit den tertiären Lichtquellen zwischen der Blendenebene APE und der Bildebene IM innerhalb des linsenfreien Zwischenraums 17. Eingezeichnet sind die Bilder der sekundären Lichtquellen 25 und 27, also die tertiären Lichtquellen 29 und 31. Da es sich um reelle Bilder handelt, könnten die Intensitätsmaxima am Ort der tertiären Lichtquellen zu Materialschädigungen führen, wenn sich im linsenfreien Zwischenraum 17 optische Elemente befinden würden. Zur Bestimmung des linsenfreien Zwischenraums 17 werden die Strahlhöhen der Strahlen 21, die von der zentralen sekundären Lichtquelle 25 ausgehen, und die Strahlhöhen der Strahlen 23, die von den außeraxialen sekundären Lichtquelle 27 ausgehen, betrachtet. Im Bereich des linsenfreien Zwischenraums 17 weisen die Strahlen 21 geringere Strahlhöhen auf als die Strahlen 23. Zur Bestimmung der axialen Dicke $d_{LF}$ des linsenfreien Zwischenraums 17 werden alle Strahlen berücksichtigt, die durch ein zentrales Feld 19 in der Eintrittsfläche 5 treten, wobei die Feldbreite des zentralen Feldes 19 50% der Breite der Eintrittsfläche 5 und die Feldhöhe 50% der Höhe der Eintrittsfläche 5 beträgt. Da deshalb neben den eingezeichneten Strahlen, die ausschließlich von der optischen Achse OA ausgehen, weitere Strahlen berücksichtigt werden, ist die axiale Dicke $d_{LF}$ des linsenfreien Zwischenraums 17 in Figur 1 geringer als dies auf Grund der eingezeichneten Strahlen zu erwarten wäre.

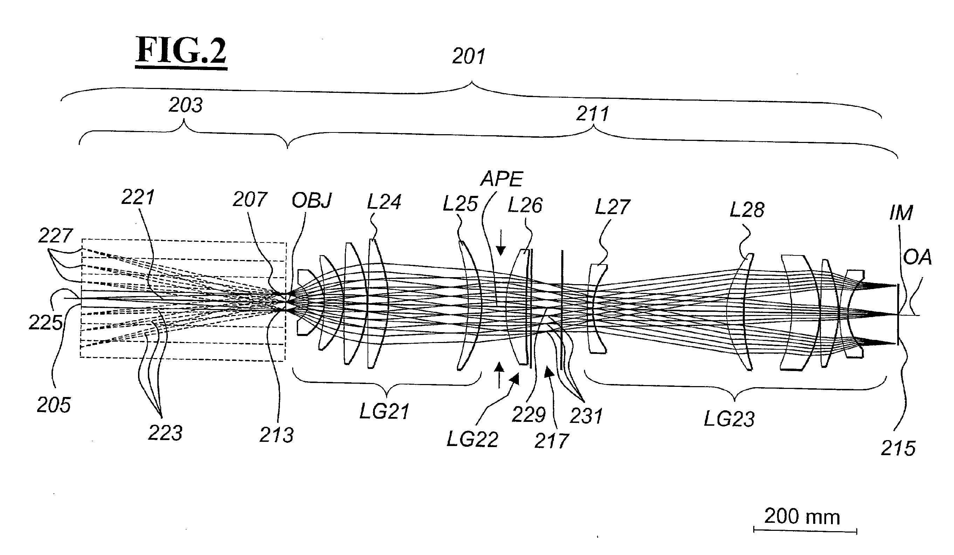

Ein erstes Ausführungsbeispiel ist in Figur 2 im x-z-Schnitt dargestellt. Die den Elementen von Figur 1 entsprechenden Elemente in Figur 2 haben die gleichen Bezugszeichen wie in Figur 1 vermehrt um die Zahl 200. Für eine Beschreibung dieser Elemente wird auf die Beschreibung zu Figur 1 verwiesen. Als Stabintegrator 203 wird ein Glasstab aus Quarz ($SiO_2$) eingesetzt, der bei der Arbeitswellenlänge $\lambda$ =248,3nm eine Brechzahl von 1,5084 aufweist. Die Eintrittsfläche 205 weist eine Breite von 32mm und eine Höhe von 7mm auf, so daß das Seitenaspektverhältnis 4,6 beträgt. Die Länge des Stabintegrators 203 beträgt 400mm. Nach dem Stabintegrator 203 folgt das Objektiv 211, wobei die Objektebene OBJ eine Defokussierung von 1,0mm zur Austrittsfläche 207 des Stabintegrators 203 aufweist. Das Objektiv 211 ist rotationssymmetrisch um die optische Achse OA aufgebaut. Die Systemdaten sind in Tabelle 1 aufgeführt. Das Objektiv 211 bildet das Objektfeld 213 mit einer Vergrößerung von β = -3,50 auf das Bildfeld 215 ab. Es besteht dabei aus der Linsengruppe LG21 zwischen der Objektebene OBJ und der Blendenebene APE, sowie den Linsengruppen LG22 und LG23 zwischen der Blendenebene APE und der Bildebene IM. Die Linsengruppe LG22 weist nur die Linse L26 auf. Das Objektfeld hat einen Durchmesser von 32,4mm. Die numerische objektseitige Apertur beträgt 0,66.

Die Abmessungen des Stabintegrators 203 sind vorteilhafterweise an das nachfolgende Objektiv 211 und an die Anforderungen bezüglich der Uniformität der Intensitätsverteilung des zu beleuchtenden Feldes angepaßt. Vorgegeben sind die Abmessungen des zu beleuchtenden Feldes innerhalb des kreisrunden Objektfeldes 213 sowie die Verteilung der Strahlwinkel vor dem Stabintegrator 203. Das zu beleuchtende Feld ist üblicherweise ein Rechteckfeld, das in das Objektfeld 213 eingeschrieben wird. Das Seitenaspektverhältnis des Stabintegrators 203 ist dabei an das Seitenaspektverhältnis des zu beleuchtenden Feldes angepaßt, wobei durch die Defokussierung der Austrittsfläche 207 von der Objektebene 213 das Seitenaspektverhältnis des Stabintegrators 203 von dem Seitenaspektverhältnis des auszuleuchtenden Feldes geringfügig abweicht. Die Breite der Eintrittsfläche $B_{SI}$ = 32mm liegt bei einem Objektfelddurchmesser $Du_{Obj}$ = 32,4mm und dem Aspektverhältnis des Stabintegrators $R_{xy}$ = 4,6 innerhalb des mit der Beziehung (2) angegebenen Zahlenbereiches für die Breite $B_{SI}$, so daß der Querschnitt des Stabintegrators 203 optimal an das Objektfeld 213 angepaßt ist.

Durch die vor dem Stabintegrator 203 angeordneten Systemkomponenten kann der Füllfaktor σ zwischen 0,36 und 1,0 angepaßt werden. Der minimale Füllfaktor beträgt somit σ = 0,36, der einer maximalen Apertur der Strahlen an der Eintritts-, beziehungsweise Austrittsfläche des Stabintegrators 203 von 0,24 entspricht. Die Anzahl der Reflexionen an den Seitenflächen des Stabintegrators 203 für einen Strahl, dessen Strahlwinkel zur optischen Achse der maximalen Apertur der Beleuchtungsstrahlen bei minimalem Füllfaktor σ entspricht, ist durch folgende Gleichung gegeben:

$$\text{Anzahl} = \frac{L_{SI} \cdot \tan\left(\arcsin\left(\frac{NA_{Obj} \cdot \sigma}{n_{SI}}\right)\right)}{B_{SI}} \qquad (3)$$

In diesem Ausführungsbeispiel ist die Anzahl der Reflexionen an den Seitenflächen gleich 2,0. Die Länge des Stabintegrators liegt somit innerhalb des mit Beziehung (2) gegebenen Zahlenbereichs, der im Mittel 1,5 bis 4,5 Reflexionen fordert.

Die Papierebene in Figur 2 stellt die x-z-Ebene dar, wobei die z-Richtung in Richtung der optischen Achse OA zeigt und die Breite der Eintrittsfläche 205 in x-Richtung gemessen wird. Der real vorhandene Stabintegrator 203 ist mit einer durchgezogenen Linie eingezeichnet. Er ist in positiver und negativer x-Richtung durch jeweils drei weitere virtuelle Stabintegratoren ergänzt, die gestrichelt eingezeichnet sind. Diese sollen die Erzeugung der virtuellen sekundären Lichtquellen 227 veranschaulichen. Jeder weitere Stabintegrator entspricht dabei einer Reflexion an einer Seitenfläche innerhalb des realen Stabintegrators 203. Die von den virtuellen sekundären Lichtquellen 227 ausgehenden Strahlen sind bis zur Austrittsfläche 207 des Stabintegrators 203 gestrichelt eingezeichnet.

Das Gitter mit den tertiären Lichtquellen, das die zentrale tertiäre Lichtquelle 229 und die außeraxialen Lichtquellen 231 umfaßt, wird in dem Objektiv 211 zwischen den Linsen L26 und L27 erzeugt, während die Blendenebene APE zwischen den Linsen L25 und L26 angeordnet ist. Die Blendenebene APE stellt dabei das Bild der im Unendlichen befindlichen Eintrittspupille durch die Linsengruppe LG21 dar.

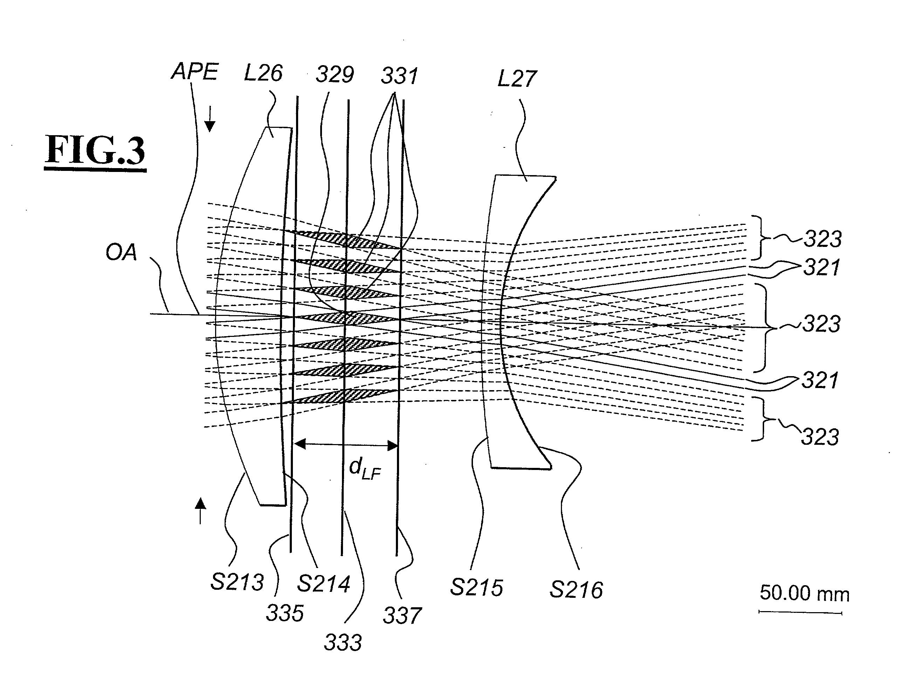

Um den linsenfreien Zwischenraum, der zwischen Linse L26 und L27 angeordnet ist, besser beschreiben zu können, zeigt Figur 3 einen vergrößerten Ausschnitt aus Figur 2. Während in Figur 2 die Strahlen von punktförmigen sekundären Lichtquellen ausgehen, gehen in Figur 3 die eingezeichneten Strahlen von ausgedehnten sekundären Lichtquellen aus. Somit sind auch die tertiären Lichtquellen 329 und 331 nicht punktförmig, sondern ausgedehnt. Sie kommen in der Ebene 333 zum Liegen, welche einen Abstand von 40mm zum Scheitel der Fläche S214 aufweist. Befindet sich das Gitter mit den virtuellen sekundären Lichtquellen in der Ebene der Eintrittsfläche 205 des Stabintegrators, so ist die Ebene 333 eine zur Ebene der Eintrittsfläche 205 optisch konjugierte Ebene. Neben der zentralen tertiären Lichtquelle 329 werden sechs außeraxiale tertiäre Lichtquellen 321 erzeugt. Die Bereiche hoher lokaler Intensität sind für die tertiären Lichtquellen 329 und 331 mit einem Strichmuster markiert. Eingezeichnet sind diejenigen Strahlen, die für die Bestimmung der axialen Dicke des linsenfreien Zwischenraums relevant sind. Die nur zwischen der Blendenebene APE und einer Fläche nach Linse L27 eingezeichneten Strahlen starten in der Eintrittsfläche des Stabintegrators bei den Objektpunkten $P_1(x = -8mm, y=0mm)$ und $P_2(x = +8mm, y=0mm)$ und schneiden die Objektebene des Objektives bei $P_3(x = -16mm, y=0mm)$, beziehungsweise bei $P_4(x = +16mm, y=0mm)$. Die Objektpunkte $P_1$ und $P_2$ begrenzen dabei das zentrale Feld in der Eintrittsfläche, während die Punkte $P_3$ und $P_4$ die Ränder des beleuchteten Bereiches in der Objektebene darstellen und die von $P_1$ und $P_2$ ausgehenden Strahlenbüschel begrenzen. Die als durchgezogene Linien eingezeichneten Strahlen 321 verlaufen ohne Reflexion an den Seitenflächen durch den Stabintegrator und gehören somit zur zentralen tertiären Lichtquelle 329. Dagegen werden die gestrichelt eingezeichneten Strahlen 323 an den Seitenflächen einmal oder mehrmals reflektiert und gehören somit zu den außeraxialen tertiären Lichtquellen 331. Zwischen den Ebenen 335 und 337 weisen die mit einer durchgezogenen Linie eingezeichneten Strahlen 321 geringere Strahlhöhen als die gestrichelt eingezeichneten Strahlen 323 auf. Genau durch diese Bedingung ist der Zwischenraum definiert, in dem sich keine Linse befinden darf. Die Ebene 335 weist einen Abstand von 5mm zum Scheitel der Fläche S214, die Ebene 337 einen Abstand von 69mm zum Scheitel der Fläche S214 auf. Die axiale Dicke $d_{LF}$ des linsenfreien Zwischenraums beträgt somit 64mm.

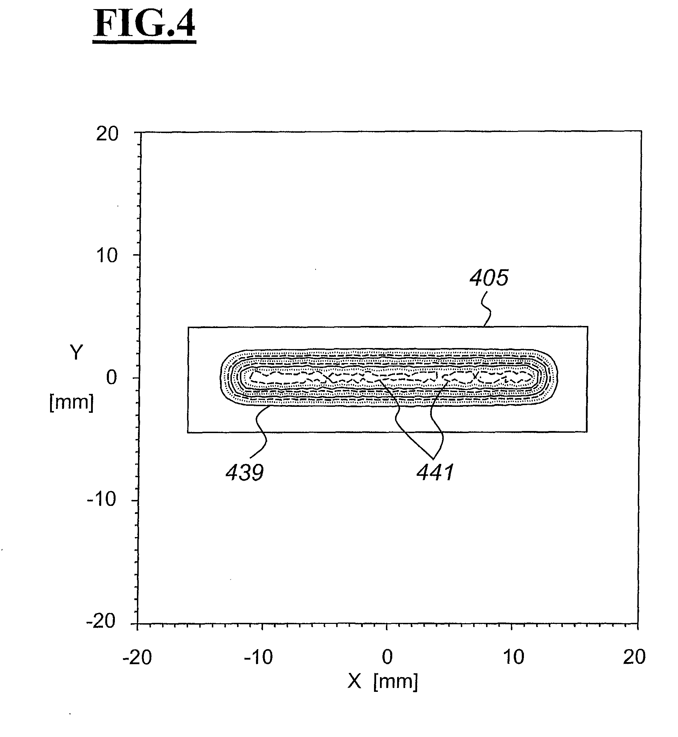

Um die Intensitätsverteilungen innerhalb des linsenfreien Zwischenraums 217 bestimmen zu können und damit die Vorteile aufzuzeigen, die sich durch den erfindungsgemäßen Aufbau des Beleuchtungssystem 201 ergeben, zeigen die Figuren 4 bis 6 Simulationsergebnisse einer Belastungsrechung in verschiedenen Ebenen des Beleuchtungssystems. In Figur 4 ist die Ausleuchtung der Eintrittsfläche 405 dargestellt, die gleich der Eintrittsfläche 205 in Figur 2 ist. Die Intensitätsverteilung ist in einem Höhenlinienplot dargestellt. Die Linie 439 gibt die 5%-Linie an, die Linie 441 die 95%-Linie der Intensitätsverteilung an. Der Abstand der 50%-Punkte in einem Schnitt entlang der x-Achse durch die Intensitätsverteilung beträgt 24mm, während der Abstand der 50%-Punkte in einem Schnitt entlang der y-Achse 2,7mm beträgt. Ein Maß für die Füllung der Eintrittsfläche ist das Produkt dieser beiden Abstände, das in diesem Fall 30% der Eintrittsfläche beträgt. Die Eintrittsfläche ist somit deutlich unterfüllt.

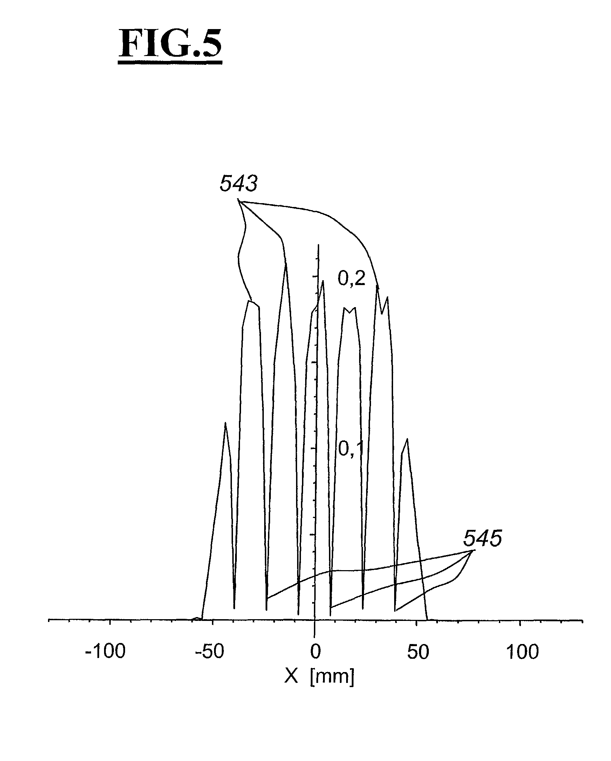

Ausgehend von der Beleuchtungsverteilung der Figur 4 in der Eintrittsfläche des Stabintegrators und einer Beleuchtungsapertur von 0,3 vor dem Stabintegrator kann die Intensitätsverteilung in der Ebene 333 der Figur 3 berechnet werden. Figur 5 zeigt einen Schnitt durch die Intensitätsverteilung entlang der x-Richtung bei y=0mm. Das Rauschen ist durch die begrenzte Anzahl der durchgerechneten Strahlen bedingt. Die Intensitätsmaxima 543 ergeben sich am Ort der tertiären Lichtquellen. Zwischen den Intensitätsmaxima 543 fällt die Intensität auf nahezu Null ab. Das Verhältnis der Intensitäten der lokalen Intensitätsmaxima 543 zu den Intensitäten der dazwischen liegenden lokalen Intensitätsminima 545 beträgt somit nahezu Unendlich. Die energetische Belastung in den lokalen Intensitätsmaxima 543 beträgt bis zu $0,2mJ/(Puls\ cm^2)$, wenn man von einer typischen Excimer-Laser-Quelle für Lithographie-Anwendungen ausgeht.

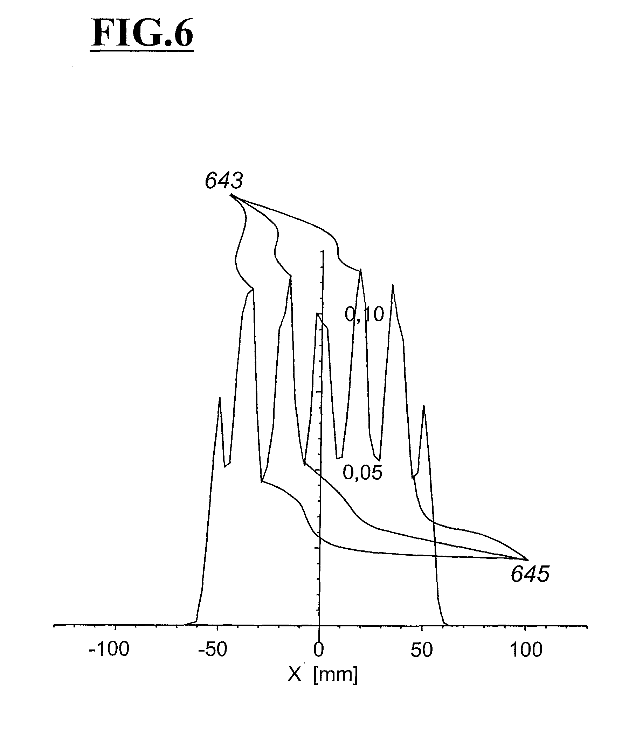

Figur 6 zeigt dagegen den Schnitt durch die Intensitätsverteilung entlang der x-Achse bei y = 0mm in der Ebene 335 der Figur 3, die den linsenfreien Zwischenraum begrenzt. Die energetische Belastung in den lokalen Intensitätsmaxima 643 beträgt nur noch $0,1mJ/(Puls\ cm^2)$, ist also um den Faktor 2 geringer. Das Verhältnis der Intensitäten der lokalen Intensitätsmaxima 643 zu den Intensitäten der dazwischen liegenden lokalen Intensitätsminima 645 beträgt in Ebene 335 nur noch 2,0. Außerhalb des linsenfreien Zwischenraums ist somit die energetische Belastung deutlich reduziert.

Zwischen der Blendenebene APE und dem linsenfreien Zwischenraum 217 befindet sich in dem Objektiv 211 der Figur 2 die Linse L26, die eine Meniskuslinse mit positiver Brechkraft ist. Die Linse L26 weist einen Abstand von 6,0mm zur Blendenebene APE auf. Die der Blendenebene APE zugewandte konvexe Linsenfläche S213 weist eine asphärische Flächenform auf, deren Flächenparameter in Tabelle 1 gegeben sind. Durch die Linse L26 mit der asphärischen Linsenfläche S213 lassen sich die Öffnungsfehler sehr gut korrigieren, da sie nahe bei der Blendenebene APE angeordnet ist. Zudem ist es mit der asphärischen Linsenfläche möglich, Korrektionsmittel einzusparen, so daß sich zwischen der Linse L26 und L27 ein gasgefüllter Luftraum mit einer axialen Dicke von 120,3mm ergibt.

Bei dem Objektiv 211 wird jeder Objektpunkt des Objektfeldes 213 in der Bildebene IM auf je ein Spotbild fokussiert. Innerhalb des Bildfeldes beträgt für alle Spotbilder der maximale Durchmesser der Spotbilder 260μm. Dieser Wert entspricht 0,2% des Bildfelddurchmesser von 113,3mm.

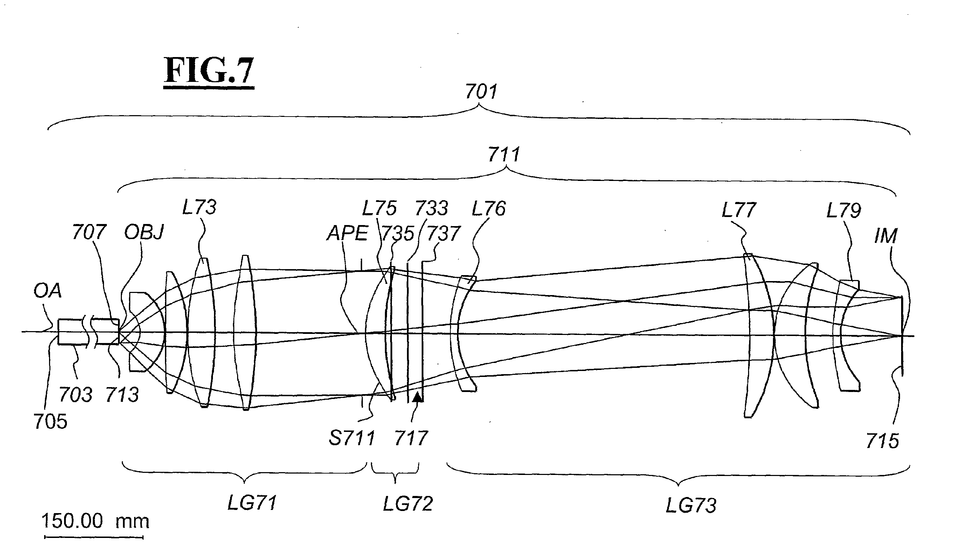

Ein zweites Ausführungsbeispiel ist in Figur 7 im x-z-Schnitt dargestellt. Die den Elementen von Figur 2 entsprechenden Elemente in Figur 7 haben die gleichen Bezugszeichen wie in Figur 2 vermehrt um die Zahl 500. Für eine Beschreibung dieser Elemente wird auf die Beschreibung zu Figur 2 verwiesen. Als Stabintegrator 703 wird ein Glasstab aus Kalziumfluorid-Kristall ($CaF_2$) eingesetzt, der bei der Arbeitswellenlänge λ =193,3nm eine Brechzahl von 1,5014 aufweist. Die Breite der Eintrittsfläche 705 beträgt 30mm, die Höhe 10mm, so daß das Seitenaspektverhältnis 3,0 beträgt. Die Länge des Stabintegrators 703 beträgt 500mm. In Figur 7 ist der Stabintegrator 703 verkürzt dargestellt. Nach dem Stabintegrator 703 folgt das Objektiv 711, wobei die Objektebene 713 eine Defokussierung von 0,8mm zur Austrittsfläche 707 des Stabintegrators 703 aufweist. Das Objektiv 711 ist rotationssymmetrisch um die optische Achse OA aufgebaut. Die Systemdaten sind in Tabelle 2 aufgeführt. Als Linsenmaterialien werden Kalziumfluorid-Kristall ($CaF_2$) und Quarz ($SiO_2$) eingesetzt, die bei der Arbeitswellenlänge λ =193,3nm eine Brechzahl von 1,5014, beziehungsweise 1,5603 aufweisen. Das Objektiv 711 bildet das Objektfeld 713 mit einer Vergrößerung von β = -3,74 auf das Bildfeld 715 ab. Es besteht dabei aus der Linsengruppe LG71 zwischen der Objektebene OBJ und der Blendenebene APE, sowie den Linsengruppen LG72 und LG73 zwischen der Blendenebene APE und der Bildebene IM. Das Objektfeld weist einen Durchmesser von 31,2mm auf. Die numerische objektseitige Apertur beträgt 0,66. Die Eintrittspupille des Objektivs 711 befindet sich im Unendlichen.

Die Abmessungen der Eintrittsfläche 705 des Stabintegrators 703 sind an das Seitenaspektverhältnis des ausgeleuchteten Feldes und an den Durchmesser des Objektfeldes 713 angepaßt. Die Breite der Eintrittsfläche $B_{SI}$ = 30mm liegt bei einem Objektfelddurchmesser $Du_{Obj}$ = 31,2mm und einem Aspektverhältnis des Stabintegrators $R_{xy}$ = 3,0 innerhalb des mit der Beziehung (2) angegebenen Zahlenbereiches für die Breite $B_{SI}$.

Durch die vor dem Stabintegrator 203 angeordneten Systemkomponenten kann der Füllfaktor σ zwischen 0,27 und 1,0 angepaßt werden. Der minimale Füllfaktor beträgt somit σ = 0,27, der einer maximalen Apertur der Strahlen an der Eintritts-, beziehungsweise Austrittsfläche des Stabintegrators 203 von 0,18 entspricht. Für einen Strahl mit diesem Aperturwinkel ist gemäß Gleichung (3) die Anzahl der Reflexionen an den Seitenflächen des Stabintegrators 703 gleich 2,0. Die Länge des Stabintegrators 703 liegt somit innerhalb des mit Beziehung (2) gegebenen Zahlenbereichs.

Das Gitter mit den tertiären Lichtquellen wird in dem Objektiv 711 zwischen den Linsen L75 und L76 in der Ebene 733 erzeugt, während die Blendenebene APE zwischen den Linsen L74 und L75 angeordnet ist. Der Abstand der Ebene 733 mit den tertiären Lichtquellen zur Linse L75 beträgt 29mm. Die Ebene 733 liegt konjugiert zu der Ebene der reellen sekundären Lichtquelle, die sich in diesem Ausführungsbeispiel am Ort der Eintrittsfläche 705 befindet.

Zwischen den Ebenen 735 und 737 weisen alle Strahlen, die von einem zentralen Feld mit einer Feldbreite von 15mm und mit einer Feldhöhe von 5mm innerhalb der Eintrittsfläche ausgehen und nicht an den Seitenwänden des Stabintegrators 703 reflektiert werden, geringere Strahlhöhen bezüglich der optischen Achse OA auf als alle Strahlen, die aus dem gleichen zentralen Feld kommen und einmal oder mehrmals reflektiert werden. Bei dem Objektiv 711 beträgt der Abstand zwischen der Linse L75 und der Ebene 735 7mm und der Abstand zwischen der Linse L75 und der Ebene 737 67mm. Die axiale Dicke des linsenfreien Zwischenraums beträgt somit 60mm.

Zwischen der Blendenebene APE und dem linsenfreien Zwischenraum 717 befindet sich die Linse L75, die eine Meniskuslinse mit positiver Brechkraft ist. Die Linse L75 weist einen Abstand von 6,0mm zur Blendenebene APE auf. Die der Blendenebene APE zugewandte konvexe Linsenfläche S714 weist eine asphärische Flächenform auf, deren Flächenparameter in Tabelle 2 gegeben sind.

Bei dem Objektiv 711 wird jeder Objektpunkt des Objektfeldes 713 in der Bildebene IM aufje ein Spotbild fokussiert. Innerhalb des Bildfeldes 715 beträgt für alle Spotbilder der maximale Durchmesser der Spotbilder 240$\mu$m. Dieser Wert entspricht 0,2% des Bildfelddurchmesser von 116,3mm.

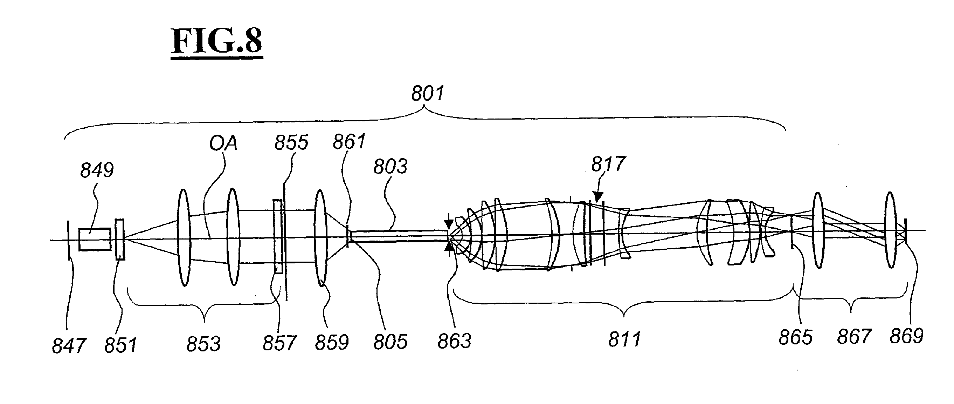

Figur 8 zeigt in schematischer Darstellung ein erstes Ausführungsbeispiel einer Mikrolithographie-Projektionsbelichtungsanlage. Als Lichtquelle 847 kann unter anderem ein DUV- oder VUV-Excimer-Laser eingesetzt werden, beispielsweise ein KrF-Laser für 248nm, in ArF-Laser für 193nm, ein $F_2$-Laser für 157nm, ein $Ar_2$-Laser für 126nm und ein NeF-Laser für 109nm. Im Ausführungsbeispiel der Figur 8 wird ein KrF-Laser für 248nm verwendet. Durch eine Strahlformungsoptik 849 wird ein paralleles Lichtbündel erzeugt, das auf ein Divergenz erhöhendes optisches Element 851 trifft. Als Divergenz erhöhendes optisches Element 851 kann beispielsweise eine Rasterplatte aus diffraktiven oder refraktiven Rasterelementen eingesetzt werden. Jedes Rasterelement erzeugt ein Strahlenbüschel, dessen Winkelverteilung durch Ausdehnung und Brennweite des Rasterelementes bestimmt ist. Die Rasterplatte befindet sich in der Objektebene eines nachfolgenden Objektives 853 oder in deren Nähe. In der Blendenebene 855 des Objektives 853 werden die von den Rasterelementen erzeugten Strahlenbüschel überlagert.

Das Objektiv 853 kann als Zoom-Objektiv auslegt sein, um die Ausdehnung der Ausleuchtung der Blendenebene 855 und damit den Füllgrad $\sigma$ zu variieren. Durch den Einsatz von zwei entlang der optischen Achse verschiebbaren Axikonlinsen unmittelbar vor der Blendenebene 855 kann auch eine annulare Ausleuchtung mit variabler Ringbreite erzielt werden. Ein derartiges Zoom-Axikon-Objektiv ist aus DE 44 41 947 A bekannt. Durch Tausch des Apertur erzeugenden Elementes 851 kann ebenfalls die Ausleuchtung und damit der Füllgrad $\sigma$ variiert werden. Spezielle Apertur erzeugende Elemente 851 lassen auch die sogenannte Quadrupol-Beleuchtung mit vier separierten Bereichen zu. In der Blendenebene 855 ist ein weiteres Divergenz erhöhendes optisches Element 857 angeordnet. Als Divergenz erhöhendes optisches Element 857 kann beispielsweise eine Rasterplatte aus diffraktiven oder refraktiven Rasterelementen eingesetzt werden. Jedes Rasterelement erzeugt ein Strahlenbüschel, dessen Winkelverteilung durch Ausdehnung und Brennweite des Rasterelementes bestimmt ist. Die Rasterelemente weisen eine rechteckige Außenform an, deren Seitenaspektverhältnis an das Seitenaspektverhältnis der Eintrittsfläche 805 des Stabintegrators 803 angepaßt ist. Mit dem Einkoppelobjektiv 859 wird die von dem Divergenz erhöhenden optischen Element 857 erzeugte Winkelverteilung in eine Ortsverteilung übersetzt und die von den Rasterelementen erzeugten Strahlenbüschel überlagert, so daß eine reelle sekundäre Lichtquelle unmittelbar vor der Eintrittsfläche 805 des Stabintegrators 803 erzeugt wird. Aufgrund der rechteckigen Form der Rasterelemente weist die reelle sekundäre Lichtquelle ebenfalls eine rechteckige Außenform auf. Die resultierende Beleuchtungsverteilung ist in Figur 4 dargestellt. Vor dem Stabintegrator ist noch eine Streuscheibe 861 angeordnet. Nach dem Stabintegrator 803 folgt die Maskierungseinrichtung 863, die mit verstellbaren mechanischen Schneiden ausgeführt ist, um die Größe des beleuchteten Feldes innerhalb des Objektfeldes des nachfolgenden Objektives 811 zu variieren. Der Stabintegrator 803 und das Objektiv 811 sind identisch zu den Komponenten aus dem ersten Ausführungsbeispiel, das mit den Figuren 2 bis 6 und den Erläuterungen dazu, sowie mit Tabelle 1 beschrieben wird. Das Objektiv 811 wird als "REMA-Objektiv" bezeichnet, da es die Maskierungseinrichtung 863 auf das Retikel 865 abbildet, das in der Bildebene des REMA-Objektives 811 angeordnet ist. Das REMA-Objektiv 811 weist neben der guten Abbildungseigenschaft, die sich in einem maximalen Durchmesser der Spotbilder von nur 260$\mu$m ausdrückt, als weiteres Merkmal die Eigenschaft auf, daß die Austrittspupille des REMA-Objektives 811 an die Eintrittspupille des nachfolgenden Projektionsobjektives 867 angepaßt ist. Dies ist dann schwierig, wenn das Projektionsobjektiv 867 eine feldabhängige Eintrittspupille aufweist. Derartige Beleuchtungssysteme werden ausführlich in der DE 195 20 563 A1 beschrieben. Für das in Figur 8 nur schematisch dargestellte Projektionsobjektiv 867 kann das Projektionsobjektiv der Figur 8 der DE 199 42 281.8 eingesetzt werden, das einen Abbildungsmaßstab von -0,25 aufweist. Die Systemdaten sind in Tabelle 4 der DE 199 42 281.8 gegeben, wobei der Abstand zwischen der Objektebene und dem Scheitel der Linse L401 33,4557mm beträgt. Das Projektionsobjektiv 867 bildet das Retikel 865 auf das lichtempfindliche Substrat 869, den sogenannten Wafer ab.

Mit den Ausführungsbeispielen wird eine Möglichkeit aufgezeigt, Beleuchtungssysteme bereit zu stellen, die einen Stabintegrator und ein nachfolgendes Objektiv aufweisen, wobei bei der Auslegung des Objektives die Abmessungen des Stabintegrators berücksichtigt werden, um Materialschäden an den Linsen des Objektives durch lokale Intensitätsspitzen zu verhindern. Dies wurde erreicht, indem die aus der DE 195 48 805 A1 und der DE 196 53 983 A1 bekannten REMA-Objektive dahingehend verbessert wurden, daß sie in einer zur Eintrittsfläche des Stabintegrators konjugierten Ebene innerhalb des REMA-Objektives einen linsenfreien Zwischenraum aufweisen. Die Erfindung zeichnet sich somit dadurch aus, daß der Stabintegrator und das nachfolgende Objektiv als funktionelle Einheit betrachtet werden.

| Linse | Fläche | Radius [mm] | Dicke [mm] | Material | Durchmesser [mm] |
|-------|--------|-------------|------------|----------|------------------|
|       | OBJ    | 0.00        | 44.12      |          | 32.4             |
| L21   | S202   | -42.28      | 30.35      | SiO2     | 73.0             |
|       | S203   | -78.14      | 0.90       |          | 121.7            |
| L22   | S204   | -338.66     | 37.30      | SiO2     | 163.1            |
|       | S205   | -124.59     | 0.86       |          | 177.2            |
| L23   | S206   | 2979.91     | *45.50*    | SiO2     | 221.0            |
|       | S207   | -219.18     | 1.65       |          | 228.3            |
| L24   | S208   | 5302.65     | 40.00      | SiO2     | 241.5            |
|       | S209   | -230.16     | 156.30     |          | 244.0            |
| L25   | S210   | -377.28     | 26.00      | SiO2     | 241.3            |
|       | S211   | -224.20     | 40.60      |          | 243.4            |
|       | APE    | 0.00        | 6.00       |          | 217.2            |
| L26   | S213   | 212.83      | 39.70      | SiO2     | 216.9            |
|       | S214   | 1296.09     | 120.30     |          | 211.7            |
| L27   | S215   | 523.30      | 11.70      | SiO2     | 166.8            |
|       | S216   | 128.28      | 148.73     |          | 155.8            |
|       | S217   | 0.00        | 113.55     |          | 233.3            |
| L28   | S218   | 146.29      | 33.90      | SiO2     | 219.7            |
|       | S219   | 345.28      | 94.30      |          | 216.2            |
| L29   | S220   | -268.89     | 55.00      | SiO2     | 208.1            |
|       | S221   | -200.89     | 0.80       |          | 216.3            |
| L210  | S222   | 1616.33     | 35.50      | SiO2     | 202.3            |
|       | S223   | -174.93     | 2.20       |          | 199.1            |
| L211  | S224   | 256.46      | 15.90      | SiO2     | 163.9            |
|       | S225   | 96.08       | 96.71      |          | 137.4            |
|       | IM     | 0.00        | 0.00       |          | 113.3            |

$$z = \frac{\frac{1}{R}h^2}{1+\sqrt{1-(1-EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

| Fläche | EX | C1 | C2 | C3 | C4 | C5 |
|--------|------|------|------|------|------|------|
| S209 | -1.1741 | 3.9084E-08 | 3.8630E-13 | 6.5586E-17 | -3.3899E-21 | 1.2432E-25 |
| S213 | -0.2501 | -2.1870E-08 | 5.4913E-14 | -7.7358E-17 | 4.1956E-21 | -1.2014E-25 |
| S218 | 0.2356 | -3.4023E-08 | -1.0405E-12 | 7.3414E-17 | -9.7841E-21 | 3.0608E-25 |
| S223 | -0.8321 | 1.4350E-07 | -4.9565E-12 | 5.7530E-16 | -3.6123E-20 | 1.5494E-24 |

Tabelle 1: Optische Daten des Objektives 211 der Figur 2

| | Fläche | Radius [mm] | Dicke [mm] | Material | Durchmesser [mm] |
|------|--------|------|------|------|------|
| | OBJ | 0.00 | 32.95 | | 31.2 |
| L71 | S702 | -38.69 | 37.88 | CaF2 | 61.9 |
| | S703 | -73.41 | 0.90 | | 114.4 |
| L72 | S704 | 2696.07 | 33.32 | CaF2 | 168.2 |
| | S705 | -191.13 | 0.90 | | 178.0 |
| L74 | S706 | 329.78 | 41.98 | SiO2 | 216.0 |
| | S707 | -514.77 | 28.53 | | 219.1 |
| L75 | S708 | 334.07 | 34.03 | SiO2 | 227.6 |
| | S709 | -570.33 | 161.49 | | 227.6 |
| | APE | 0.00 | 6.00 | | 188.0 |
| L76 | S711 | 130.20 | 30.35 | SiO2 | 195.8 |
| | S712 | 324.12 | 99.95 | | 192.5 |
| L77 | S713 | 211.39 | 11.40 | SiO2 | 168.8 |
| | S714 | 127.10 | 230.32 | | 158.8 |
| | S715 | 0.00 | 216.90 | | 197.4 |
| L78 | S716 | -851.36 | 37.33 | SiO2 | 237.1 |
| | S717 | -237.99 | 0.90 | | 240.0 |
| L79 | S718 | 133.05 | 46.59 | SiO2 | 212.7 |
| | S719 | 275.70 | 42.03 | | 200.4 |
| L710 | S720 | 240.69 | 12.00 | SiO2 | 162.1 |
| | S721 | 101.80 | 91.62 | | 138.5 |
| | IM | 0.00 | 0.00 | | 116.2 |

$$z = \frac{\frac{1}{R} h^2}{1 + \sqrt{1 - (1 - EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

Tabelle 2:

| Optische Daten des Objektives 711 der Figur 7 | | | | | |
|---|---|---|---|---|---|
| Fläche | EX | C1 | C2 | C3 | C4 |
| S708 | -2.4978 | -4.3481E-08 | -7.8594E-14 | -2.0935E-17 | 8.6082E-23 |
| S711 | 0.2840 | -4.1616E-08 | -1.1523E-12 | -4.8136E-18 | -5.8384E-21 |
| S713 | 0.6222 | -3.5043E-08 | 1.0875E-12 | 2.1557E-16 | -3.6907E-21 |
| S720 | 0.9715 | -5.9896E-08 | -2.8284E-12 | 1.2407E-16 | 2.9936E-21 |

**Patentansprüche**

1. Beleuchtungssystem (1, 201, 701, 801) insbesondere für eine Mikrolithographie-Projektionsbelichtungsanlage, mit einer optischen Achse (OA), umfassend

   - einen Stabintegrator (3, 203, 703, 803), wobei der Stabintegrator (3, 203, 703, 803) eine Eintrittsfläche (5, 205, 705, 805) und eine Austrittsfläche (7, 207) aufweist,
   - ein Objektiv (11, 211, 711, 811) zur Abbildung eines Objektfeldes (13, 213, 713) auf ein Bildfeld (15, 215, 715), wobei das Objektiv (11, 211, 711, 811) in Lichtrichtung nach dem Stabintegrator (3, 203, 703, 803) angeordnet ist,

   **dadurch gekennzeichnet, daß**

   - sich in dem Objektiv (11, 211, 711, 811) ein linsenfreier Zwischenraum (17, 217, 717, 817) befindet,
   - sich innerhalb des linsenfreien Zwischenraums (17, 217, 717, 817) eine zur Ebene der Eintrittsfläche (5, 205, 705, 805) optisch konjugierte Ebene (333, 733) befindet, und
   - der linsenfreie Zwischenraum (17, 217, 717, 817) entlang der optischen Achse (OA) eine axiale Dicke ($d_{LF}$) von mindestens 30mm, insbesondere von mindestens 50mm aufweist.

2. Beleuchtungssystem (1, 201, 701, 801) insbesondere für eine Mikrolithographie-Projektionsbelichtungsanlage, mit einer optischen Achse (OA), umfassend

   - einen Stabintegrator (3, 203, 703, 803), wobei der Stabintegrator (3, 203, 703, 803) eine Eintrittsfläche (5, 205, 705, 805) und eine Austrittsfläche (7, 207) mit einer Breite und einer Höhe und reflektierende Seitenflächen (9) aufweist,
   - ein Objektiv (11, 211, 711, 811) zur Abbildung eines Objektfeldes (13, 213, 713) auf ein Bildfeld (15, 215, 715), wobei das Objektiv (11, 211, 711, 811) in Lichtrichtung nach dem Stabintegrator (3, 203, 703, 803) angeordnet ist,

   **dadurch gekennzeichnet, daß**

   - sich in dem Objektiv (11,211,711,811) ein linsenfreier Zwischenraum (17, 217, 717, 817) befindet,
   - innerhalb dieses Zwischenraums (17, 217, 717, 817) erste Strahlen (21, 221, 321) in Bezug auf die optische Achse (OA) erste Strahlhöhen aufweisen und zweite Strahlen (23, 223, 323) in Bezug auf die optische Achse (OA) zweite Strahlhöhen aufweisen,

     wobei die ersten Strahlhöhen kleinere Werte aufweisen als die zweiten Strahlhöhen,
     wobei die zweiten Strahlen (23, 223, 323) an den Seitenflächen (9) des Stabintegrators (3) reflektiert werden, während die ersten Strahlen (21, 221, 321) nicht an den Seitenflächen (9) des Stabintegrators (3) reflektiert werden, wobei alle ersten Strahlen (21, 221, 321) und alle zweiten Strahlen (23, 223, 323) von einem zentralen Feld (9) innerhalb der Eintrittsfläche (5) des Stabintegrators (3) ausgehen, und
     wobei das zentrale Feld (19) eine Feldbreite und eine Feldhöhe aufweist und das Verhältnis der Feldbreite zur Breite der Eintrittsfläche (5) maximal 0,7, insbesondere maximal 0,5, und das Verhältnis der Feldhöhe zur Höhe der Eintrittsfläche (5) maximal 0,7, insbesondere maximal 0,5, beträgt.

**3.** Beleuchtungssystem nach Anspruch 2,
wobei der linsenfreie Zwischenraum (17, 217, 717, 817) entlang der optischen Achse (OA) eine axiale Dicke ($d_{LF}$) von mindestens 30mm, insbesondere von mindestens 50mm aufweist.

**4.** Beleuchtungssystem nach einem der Ansprüche 1-3,
wobei das Objektiv (11, 211, 711) einen Durchmesser des Objektfeldes (13, 213, 713) und eine objektseitige numerische Apertur aufweist und wobei der Durchmesser des Objektfeldes (13, 213, 713) zwischen 15mm und 40mm beträgt und die objektseitige numerische Apertur zwischen 0,4 und 0,75 beträgt.

**5.** Beleuchtungssystem nach einem der Ansprüche 1-4,
mit einem Durchmesser $Du_{Obj}$ des Objektfeldes (13, 213, 713), einem Seitenaspektverhältnis $R_{xy}$, welches als Quotient einer Breite und einer Höhe der Eintrittsfläche (5, 205, 705, 805) gegeben ist und Werte zwischen 1 und 5 annimmt, einer Länge $L_{SI}$ des Stabintegrators (3, 203, 703, 803) entlang der optischen Achse (OA), einen Füllfaktor $\sigma$, welcher den Quotienten der maximalen Apertur aller Strahlen an der Eintrittsfläche (5, 205, 705, 805) und der objektseitigen numerischen Apertur $NA_{Obj}$ angibt und Werte zwischen 0,2 und 1,0 annimmt, und einem Brechungsindex $n_{SI}$ innerhalb des Stabintegrators (3, 203, 703, 803) mit Werten zwischen 1,0 und 1,8, wobei die Breite $B_{SI}$ Werte im Bereich

$$0,8 \cdot Du_{Obj} \cdot \sqrt{1+\frac{1}{R_{xy}^2}} < B_{SI} < 1,2 \cdot Du_{Obj} \cdot \sqrt{1+\frac{1}{R_{xy}^2}}$$

und die Länge $L_{SI}$ Werte im Bereich

$$1,5 \cdot \frac{B_{SI}}{\tan\left(\arcsin\left(\frac{NA_{Obj} \cdot \sigma}{n_{SI}}\right)\right)} < L_{SI} < 4,5 \cdot \frac{B_{SI}}{\tan\left(\arcsin\left(\frac{NA_{Obj} \cdot \sigma}{n_{SI}}\right)\right)}$$

annimmt.

**6.** Beleuchtungssystem nach einem der Ansprüche 1-5,
wobei der Stabintegrator (3, 203, 703, 803) eine Länge zwischen 350mm und 800mm aufweist.

**7.** Beleuchtungssystem nach einem der Ansprüche 1-6,
wobei das Objektiv (11, 211, 711, 811) eine Eintrittspupille aufweist, die sich im Unendlichen befindet.

**8.** Beleuchtungssystem nach einem der Ansprüche 1-7,
wobei das Objektiv (11, 211, 711, 811) eine Blendenebene (APE) aufweist und zwischen der Blendenebene (APE) und dem linsenfreien Zwischenraum (17, 217, 717, 817) mindestens eine erste Linse (L1, L26, L75) angeordnet ist.

**9.** Beleuchtungssystem nach Anspruch 8,
wobei die erste Linse (L26, L75) einen Abstand zur Blendenebene (APE) aufweist, der kleiner 30mm, insbesondere kleiner 10mm ist.

**10.** Beleuchtungssystem nach einem der Ansprüche 8 und 9,
wobei die erste Linse (L26, L75) eine asphärische Linsenfläche (S313, S711) aufweist.

**11.** Beleuchtungssystem nach einem der Ansprüche 8-10,
wobei sich zwischen der Blendenebene (APE) und dem linsenfreien Zwischenraum (217, 717) genau eine Linse (L26, L75) befindet.

**12.** Beleuchtungssystem nach einem der Ansprüche 1-11,
mit einem Seitenaspektverhältnis, welches als Quotient einer Breite und einer Höhe der Eintrittsfläche (5, 205, 405, 705, 805) gegeben ist,
wobei das Seitenaspektverhältnis mindestens 2, insbesondere mindestens 3, besonders bevorzugt mindestens 4 beträgt.

13. Beleuchtungssystem nach einem der Ansprüche 1-12,
   wobei das Bildfeld (15, 215, 715) einen Durchmesser aufweist,
   das Objektiv (11, 211, 711) von jedem Objektpunkt innerhalb des Objektfeldes (13, 213, 713) ein Spotbild innerhalb des Bildfeldes (15, 215, 715) erzeugt und die Durchmesser der Spotbilder maximal 1% des Durchmessers des Bildfeldes (15, 215, 715) betragen.

14. Beleuchtungssystem nach einem der Ansprüche 1-13,
   wobei das Beleuchtungssystem (801) als Lichtquelle (847) einen Excimer-Laser zur Erzeugung von UV-Strahlen mit Wellenlängen kleiner 250nm umfaßt.

15. Beleuchtungssystem nach einem der Ansprüche 1-14,
   wobei das Objektiv (11, 211, 711, 811) ein REMA-Objektiv zur Abbildung einer Maskierungseinrichtung (863) auf eine Struktur tragende Maske (865) ist,
   die Maskierungseinrichtung (863) in der Objektebene des REMA-Objektives und die Struktur tragende Maske (865) in der Bildebene des REMA-Objektives angeordnet ist.

16. Mikrolithographie-Projektionsbelichtungsanlage, umfassend

   - ein Beleuchtungssystem (801) nach Anspruch 15,
   - ein Projektionsobjektiv (867), das die Struktur tragende Maske (865) auf ein lichtempfindliches Substrat (869) abbildet.

# FIG.1

EP 1 235 113 A2

**FIG.2**

EP 1 235 113 A2

200 mm

**FIG.3**

EP 1 235 113 A2

50.00 mm

# FIG.4

# FIG.5

# FIG.6

EP 1 235 113 A2

# FIG.7

FIG.8

EP 1 235 113 A2